# EUROPEAN PATENT APPLICATION

(11) **EP 4 307 359 A1**
(43) Date of publication of application: **17.01.2024**
(21) Application number: 22185078.7
(22) Date of filing: 15.07.2022
(51) Int. Cl.: H01L 23/053, H01L 21/48, H01L 23/24, H01L 25/07, H01L 23/373, H01L 23/40, H01L 23/498

(54) **POWER SEMICONDUCTOR MODULE ARRANGEMENT AND METHOD FOR PRODUCING THE SAME**

(71) Applicant: Infineon Technologies AG, 85579 Neubiberg (DE)
(72) Inventor: HAMADI, Thomas, 44135 Dortmund (DE); HOHLFELD, Olaf, 29581 Warstein (DE); MICHALSKI, Sebastian, 59557 Lippstadt (DE)
(74) Representative: Westphal, Mussgnug & Partner, Patentanwälte mbB

(57) **Abstract**

A power semiconductor module arrangement (200) comprises an integrated base plate (90) arranged on a mounting surface (82) and comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902), a housing (7) arranged on the first metallic layer (902) of the integrated base plate (90), a plurality of mounting elements (952), and a plurality of screws (950), each of the plurality of screws (950) comprising a shaft and a head, wherein the shaft of each of the plurality of screws (950) extends through a threaded hole in one of the plurality of mounting elements (952) and into a threaded hole in the mounting surface (82), the head of each of the plurality of screws (950) exerts pressure on one of the plurality of mounting elements (952) in a vertical direction (y) towards the mounting surface (82), each of the plurality of mounting elements (952) is attached to or monolithically formed with the housing (7), and the plurality of mounting elements (952) are configured to transfer the pressure exerted on the mounting elements (952) by means of the screws (950) to the housing (7) such that the housing (7) is pressed on the first metallic layer (902).

## Description

### TECHNICAL FIELD

The instant disclosure relates to a power semiconductor module arrangement and to a method for producing such a power semiconductor module arrangement.

### BACKGROUND

Power semiconductor module arrangements often include a base plate within a housing. At least one substrate is arranged on the base plate. A semiconductor arrangement including a plurality of controllable semiconductor elements (e.g., two IGBTs in a half-bridge configuration) is arranged on each of the at least one substrate. The base plate may be mounted on a planar mounting surface. This mounting surface may comprise a surface of a heat sink, for example. Conventional substrates usually comprise a substrate layer (e.g., a ceramic layer), a first metallization layer deposited on a first side of the substrate layer and a second metallization layer deposited on a second side of the substrate layer. Alternatively, base plates are known which have a substrate already integrated. Such base plates usually comprise comparably soft metals. A housing is often mounted on an (integrated) base plate to cover the at least one (integrated) substrate and the semiconductor arrangement arranged thereon. The housing not only protects the semiconductor arrangement from environmental impacts, but is usually also used to press the base plate against a mounting surface. The housing is often securely attached to the base plate by means of screws at defined positions, the screws pressing the housing on the base plate and further the base plate on the mounting surface. When a housing exerts pressure on the soft metal of an integrated base plate, the soft metal may deform over time which may, eventually, result in a decreased pressure between the housing and the mounting surface.

There is a need for a power semiconductor module arrangement that reduces or even avoids the drawbacks mentioned above as well as others and for a method which allows to produce power semiconductor module arrangements with an increased performance and reliability.

### SUMMARY

A power semiconductor module arrangement includes an integrated base plate arranged on a mounting surface and including a first metallic layer, a ceramic substrate bonded directly to a first surface of the first metallic layer, a second metallic layer bonded directly to the ceramic substrate such that the ceramic substrate is arranged between the first metallic layer and the second metallic layer, and a reinforcing layer embedded in the metallic layer and having a greater strength than the first metallic layer, a housing arranged on the first metallic layer of the integrated base plate, a plurality of mounting elements, and a plurality of screws, each of the plurality of screws including a shaft and a head, wherein the shaft of each of the plurality of screws extends through a threaded hole in one of the plurality of mounting elements and into a threaded hole in the mounting surface, the head of each of the plurality of screws exerts pressure on one of the plurality of mounting elements in a vertical direction towards the mounting surface, each of the plurality of mounting elements is attached to or monolithically formed with the housing, and the plurality of mounting elements are configured to transfer the pressure exerted on the mounting elements by means of the screws to the housing such that the housing is pressed on the first metallic layer.

A method includes arranging an integrated base plate on a mounting surface, the integrated base plate including a first metallic layer, a ceramic substrate bonded directly to a first surface of the first metallic layer, a second metallic layer bonded directly to the ceramic substrate such that the ceramic substrate is arranged between the first metallic layer and the second metallic layer, and a reinforcing layer embedded in the metallic layer and having a greater strength than the first metallic layer, arranging a housing on the first metallic layer of the integrated base plate, wherein a plurality of mounting elements is attached to or monolithically formed with the housing, and wherein each of the plurality of mounting elements comprises at least one threaded hole, inserting one of a plurality of screws through each of the plurality of threaded holes in the mounting elements such that a shaft of each of the plurality of screws extends through the respective through hole and into one of a plurality of threaded holes in the mounting surface, and fastening the plurality of screws such that the head of each of the plurality of screws exerts pressure on the respective one of the plurality of mounting elements in a vertical direction towards the mounting surface, wherein the pressure exerted on the mounting elements by means of the screws is transferred to the housing by means of the mounting elements such that the housing is pressed on the first metallic layer.

A power semiconductor module according to another example includes an integrated base plate including a first metallic layer, a ceramic substrate bonded directly to a first surface of the first metallic layer, a second metallic layer bonded directly to the ceramic substrate such that the ceramic substrate is arranged between the first metallic layer and the second metallic layer, and a reinforcing layer embedded in the metallic layer and having a greater strength than the first metallic layer, and a housing, wherein the first metallic layer includes a plurality of openings extending from the first surface towards the reinforcing layer such that defined portions of the reinforcing layer are not covered by the first metallic layer, and the housing is arranged on the first metallic layer and includes a plurality of protrusions, each of the plurality of protrusions extending into a different one of the plurality of openings and contacting the reinforcing layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3 is a cross-sectional view of a power semiconductor module arrangement according to one example.
Figure 4 is a cross-sectional view of a power semiconductor module arrangement according to another example.
Figure 5 is a cross-sectional view of a power semiconductor module arrangement according to another example.
Figure 6 is a cross-sectional view of a power semiconductor module arrangement according to an even further example.
Figure 7 schematically illustrates a top view of a base plate of the arrangement of Figure 6.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

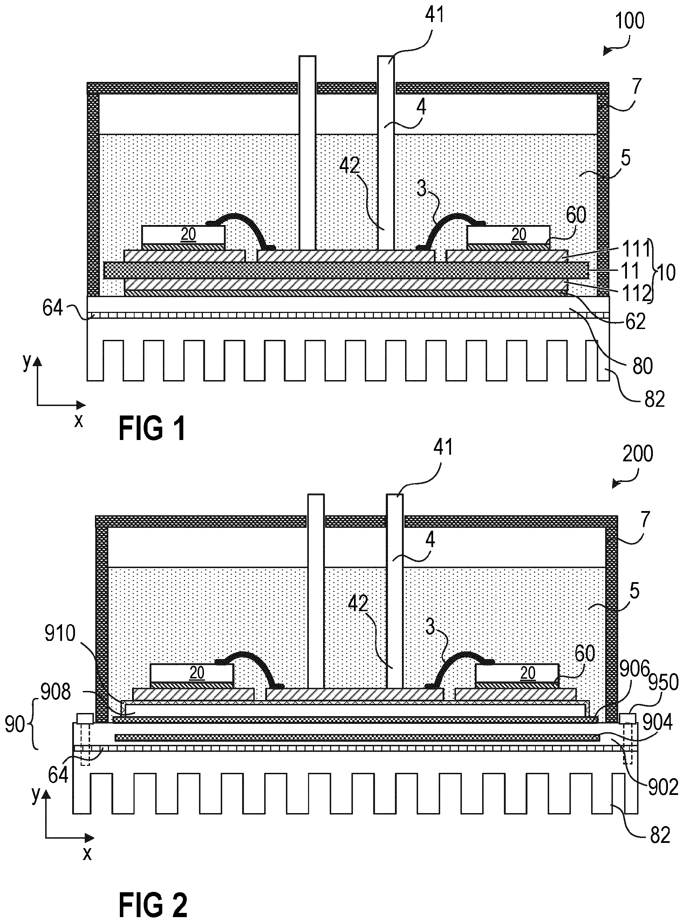

Referring to Figure 1, a cross-sectional view of a conventional power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 80 which forms a base surface of the housing 7, while the housing 7 itself solely comprises sidewalls and a cover. In some power semiconductor module arrangements 100, more than one substrate 10 is arranged on the same base plate 80 and within the same housing 7. The base plate 80 may comprise a layer of a metallic material such as, e.g., copper or AlSiC. Other materials, however, are also possible.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate by means of ultrasonic welding.

The power semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

During the use of the power semiconductor module arrangement 100, the electrically conductive connection layer 60, the dielectric insulation layer 11, the first metallization layer 111, and the second metallization layer 112 may be heated to a certain degree. This is because at least some semiconductor bodies 20 of the power semiconductor module arrangement 100 generally perform a plurality of switching operations during the operation of the power semiconductor module arrangement 100. When performing many switching operations within a short period of time, for example, the semiconductor bodies 20 generate heat which, in the worst case, may rise to a temperature above a certain maximum threshold. Heat generated during the operation of the power semiconductor module arrangement 100 is usually dissipated from the semiconductor bodies 20 to the substrate 10 and further through the base plate 80 to a mounting surface 82, which may be the surface of a heat sink, for example. A first heat conducting layer 62 is generally arranged between the substrate 10 and the base plate 80, and a second heat conducting layer 64 is arranged between the base plate 80 and the mounting surface 82.

The heat dissipation from the substrate 10 to the mounting surface 82, however, may not be satisfactory in many cases. The heat conducting layers 62, 64, for example, may have an insufficient thermal conductivity.

Now referring to Figure 2, a power semiconductor module arrangement 200 comprising an integrated base plate 90 is schematically illustrated. Most components of the power semiconductor module arrangement 200 of Figure 2 correspond to the components that have been described with respect to Figure 1 above (e.g., semiconductor bodies 20, electrical connections 3, terminal elements 4, encapsulant 5, housing 7, mounting surface 82). The structure of the base plate and substrate, however, differs from what has been described with respect to Figure 1 above. In particular, Figure 2 schematically illustrates a base plate with an integrated substrate which is referred to as integrated base plate 90 in the following. A first metallic layer 902 essentially forms the base plate. The first metallic layer 902 may comprise or consist of one of the following materials: aluminum; an aluminum alloy. A ceramic substrate 906 is bonded directly to the first metallic layer 902. The ceramic substrate 906 may comprise at least one of alumina, aluminum nitride, silicon nitride and silicon carbide, for example. A second metallic layer 908 is bonded directly to the other side of the substrate 906. The second metallic layer 908 may comprise or consist of one of the following materials: aluminum; an aluminum alloy. The second metallic layer 908 may consist of the same material as the first metallic layer 902, for example. The second metallic layer 908 essentially corresponds to (has the same function as) the first metallization layer 111, as has been described with respect to Figure 1 above. That is, the second metallic layer 908 may be structured to form circuit patterns. Semiconductor bodies 20 may be arranged on the second metallic layer 908, similar to what has been described with respect to Figure 1 above. The second metallic layer 908 may optionally be coated by a thin coating layer 910. Such a coating layer 910 may consist of or include nickel, silver, gold, or palladium, for example. The optional coating layer 910 may improve the solderability of the second metallic layer 908.

In the first metallic layer 902, a plate-shaped reinforcing layer 904 is arranged in a plane substantially parallel to the bonding surface of the first metallic layer 902 and to the ceramic substrate 906. The surface of the reinforcing layer 904 is bonded directly to the first metallic layer 902. In particular, the reinforcing layer 904 may be embedded in the metallic layer 902. The reinforcing layer 904 may be a metallic or a ceramic layer, for example. In particular, the reinforcing layer 904 may consist of a metallic or ceramic material that has a higher melting point and a higher strength than the material of the first metallic layer 902 in order to provide stability to the base plate. In this way, a warpage of the integrated base plate 90 (i.e. the warpage of the first metallic layer 902 and the substrate 906) may be decreased. The reinforcing layer 904 may comprise or consist of a ceramic material such as AlN, Al₂O₃, SiC, BeO, BN, or Si₃N₄, for example. The reinforcing layer 904 is not in direct contact with the ceramic substrate 906. A section of the first metallic layer 902 is arranged between and separates the reinforcing layer 904 and the ceramic substrate 906.

The integrated base plate 90 as described by means of Figure 2 has several advantages, e.g., with regard to heat dissipation, as compared to the arrangement described by means of Figure 1 above. A housing 7 can be mounted to a base plate by a variety of means, including adhesives or threaded fasteners (not specifically illustrated). The power semiconductor module arrangement 200 (i.e., the integrated base plate 90 with any elements arranged thereon) can be mounted to the mounting surface 82 by means of screws 950, for example, as is schematically illustrated in Figure 2. The screws 950 may penetrate through the base plate 90 (the first metallic layer 902 in the example of Figure 2) and into the mounting surface 82, thereby attaching the base plate 90 to the mounting surface 82. In particular, the base plate 90 is usually pressed on the mounting surface 82 in order to increase the heat dissipation between the base plate 90 and the mounting surface 82. Several screws 950 are usually arranged at dedicated positions along the circumference of the power semiconductor module arrangement 200 (i.e., along the circumference of the integrated base plate 90). As the material of the first metallic layer 902 however is generally comparably soft, the screws 950 may cause the material of the first metallic layer 902 to creep as a reaction of the pressure caused by the screws 950, resulting in undesired marks and a (deep) imprint in the first metallic layer 902. Creep is generally understood to be a type of metal deformation that occurs at stresses below the yield strength of a material, particularly during the elevated temperatures a power module generates during operation. Over time, this creep is likely to result in a decreased force with which the integrated base plate 90 is pressed on the mounting surface 82. This may negatively affect the performance of the power semiconductor arrangement 200, as heat will be less effectively conducted away from the integrated base plate 90.

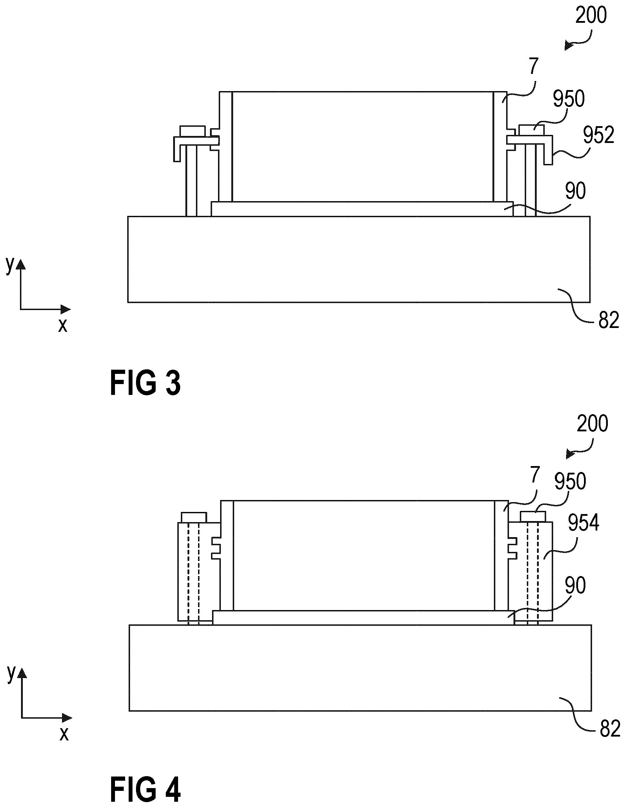

Now referring to Figure 3, a power semiconductor module arrangement 200 according to one example is schematically illustrated. The power semiconductor module arrangement 200 comprises an integrated base plate 90. The different layers of the integrated base plate 90 are not specifically illustrated in Figure 3 for the sake of clarity. The integrated base plate 90 may be arranged on a mounting surface 82. A housing 7 is arranged on the integrated base plate 90. Semiconductor bodies 20 arranged on the integrated base plate 90 are not specifically illustrated in Figure 3. The housing 7 may be arranged to essentially cover one side of the integrated base plate 90 and any semiconductor bodies 20 or other components arranged thereon. The housing 7 comprises sidewalls and a cover. The cover, however, could be omitted or could be provided as a separate element. A plurality of mounting elements 952 are mounted to the sidewalls of the housing 7. The mounting elements 952 may be formed by means of bars or protrusions which extend horizontally from the sidewalls of the housing 7. That is, the protrusions forming the mounting elements 952 may extend essentially in parallel to the first surface of the first metallic layer 902. One or more threaded holes may be provided in each of the mounting elements 952. One of a plurality of screws 950 may be arranged in a different one of the plurality of threaded holes. Each of the plurality of screws extends from the respective mounting element 952 towards the mounting surface 82.

A plurality of threaded holes may be provided in the mounting surface 82. Each of the plurality of screws 950 extends into one of the plurality of threaded holes provided in the mounting surface 82. By fastening the screws 950, the mounting elements 952 are pushed towards the mounting surface 82, as the screw 950 (i.e., the shaft) is screwed in the threaded holes in the base plate 82, and a head of the screw 950 is thereby pressed against the mounting element 952 in a vertical direction towards the mounting surface 82. As the mounting elements 952 are attached to the sidewalls of the housing 7, pushing the mounting elements 952 towards the mounting surface 82 results into pressing the housing 7 on the integrated base plate 90, and the integrated base plate 90, which is arranged between the housing 7 and the mounting surface 82, is pressed on the mounting surface 82. In particular, the housing 7 is pressed on the integrated base plate 90 along its entire circumference. The comparably strong pressing force exerted on the mounting elements 952 by fastening the screws 950, therefore, is transferred from the mounting elements 952 to the housing 7 and is evenly distributed over a comparably large surface. The contact surface between the sidewalls of the housing 7 and the integrated base plate 90 is generally significantly larger than the contact surface between the screw 950 (i.e., the screw head) and the respective mounting element 952. Because the contact area is increased, the force applied at any given point on the baseplate 90 is decreased such that the likelihood of creep at any point in the first metallic layer 902 is significantly reduced.

Figure 3 exemplarily illustrates mounting elements 952 which may be easily mounted to the sidewalls of the housing 7. The sidewalls in this example comprise grooves and the mounting elements 952 may simply engage with a respective one of the grooves. The mounting elements 952 in this example are separate elements and do not directly contact the integrated base plate 90.

According to another example, which is schematically illustrated in Figure 4, it is also possible that the mounting elements 952 contact the integrated base plate 90. In this way, the contact surface between the housing 7 and the integrated base plate 90 may be enlarged even further. The mounting elements 952 in Figure 4 are also illustrated as separate elements that are mounted to the housing 7 by means of grooves. The mounting elements as illustrated in Figures 3 and 4, however, may also be attached to the sidewalls of the housing 7 in any other suitable way. It is also possible that the mounting elements 952 are monolithically formed with the housing 7 and may be regarded as part of the housing 7.

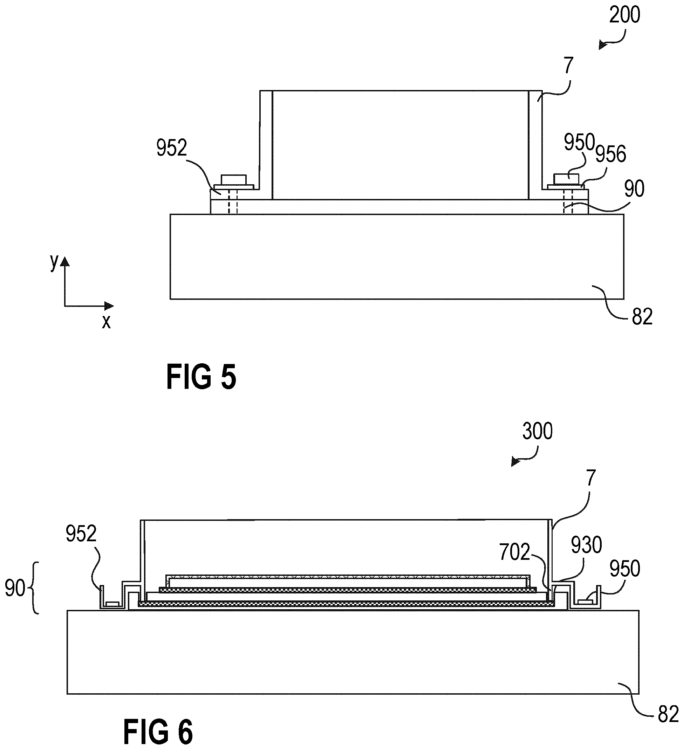

Now referring to Figure 5, a power semiconductor module 200 according to another example is schematically illustrated. In this example the mounting elements 952 are formed by protrusions integrally formed with the housing 7. The protrusions enlarge the contact area between the housing 7 and the integrated base plate 90. However, the thickness of the sidewalls of the housing 7 is only increased in a section directly adjacent to the integrated base plate 90 in order to form the protrusions. The remaining sections of the sidewalls are significantly thinner. In this way, less material is needed to form the sidewalls as compared to the example of Figure 4 in which almost the entire thickness of the sidewalls is increased by the mounting elements 952. In the example of Figure 5, the arrangement further comprises washers 956 arranged between the screw heads and the mounting elements 952. In this way, the pressure that is exerted on the mounting elements 952 by the screws 950 is distributed over the much larger contact surface between the housing 7 and the integrated base plate 90. A contact surface between the washers 956 and the mounting elements 952 is larger than a contact surface between the screws 950 (screw heads) and the washers 956. The contact surface may be enlarged even further by means of the mounting elements and by further transferring the pressure to the housing 7 and distributing it evenly along the circumference of the housing 7.

In the examples illustrated above, a contact surface over which the pressure is distributed on the integrated substrate 90 is at least twice as large as the contact surface between the screw 950 (i.e., the screw head) and the mounting element 952. According to another example, the contact surface over which the pressure is distributed on the integrated substrate 90 is at least 10 times, or even at least 20 times as large as the contact surface between the screw 950 (i.e., the screw head) and the mounting element 952.

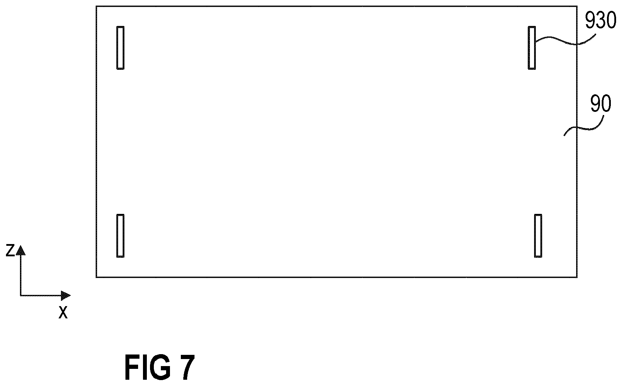

Distributing the pressure exerted by the plurality of screws 950 over a large contact area, however, is only one example. When forming an integrated base plate 90, the reinforcing layer 904 needs to be held in a desired position while the first metallic layer 902 is formed to enclose the reinforcing layer 904. A holding device may be used for this purpose. The reinforcing layer 904 needs to be held in place until the entire first metallic layer 902 has been formed. Therefore, a finished integrated base plate 90 may comprise a plurality of openings 930 in those positions where the holding device made contact with the reinforcing layer 904 during production of the integrated base plate 90. A top view of an exemplary integrated base plate 90 comprising a plurality of openings 930 is schematically illustrated in Figure 7. In this example, the first metallic layer 902 comprises four openings 930, one at each corner of the rectangular integrated base plate 90. Any other number of openings 930 is also possible. The openings 930 can also be arranged at different positions on the substrates 90. The openings 930, however, are usually arranged close to the edges of the substrate 90, as the more central areas of the substrate 90 are usually covered by the ceramic substrate 906 to provide an area for mounting a circuit arrangement.

Each of the plurality of openings 930 extends from the first surface of the first metallic layer 902 towards the reinforcing layer 904 such that defined portions of the reinforcing layer 904 are not covered by the first metallic layer 902. An integrated base plate 90 comprising four openings 930 is only an example. Any other number of openings 930 is possible, depending on the number of contact points that are required to hold the reinforcing layer 904 in place by means of a holding device.

The openings 930 that are already present for production reasons may be used to exert pressure on the integrated substrate 90. In particular, the housing 7 which is arranged on the first metallic layer 902 may comprise a plurality of protrusions 702, each of the plurality of protrusions 702 extending in a vertical direction y towards the substrate 90 and into a different one of the plurality of openings 930 and contacting the reinforcing layer 904. This is schematically illustrated in Figure 6. The housing 7 may comprise mounting elements 952, similar to the mounting elements 952 that have been described above. Screws 950 may extend through threaded holes in the mounting elements 952 and into threaded holes in a mounting surface 82, for example, thereby mounting the housing 7 on the mounting surface 82. When the screws 950 are fastened, the protrusions 702 of the housing 7 which extend into the openings 930 exert pressure on the reinforcing layer 904. As has been described above, the reinforcing layer 904 is significantly harder than the first metallic layer 902. Therefore, even if the points of contact between the protrusions 702 and the reinforcing layer 904 are comparably small, the pressure is exerted on a material that is harder than the metallic material of the first metallic layer 902. The reinforcing layer 904 does not creep as easily under pressure as the first metallic layer 902.

The reinforcing layer 904, on the other hand, distributes the pressure exerted by the housing 7 on a significantly larger area of the first metallic layer 902, i.e., those parts of the first metallic layer 902 that are arranged between the reinforcing layer 904 and the mounting surface 82. Therefore, there is no risk that those sections of the first metallic layer 902 that are arranged between the reinforcing layer 904 and the mounting surface 82 creep under the pressure applied by the screws 950.

## Claims

1. A power semiconductor module arrangement (200) comprising:
an integrated base plate (90) arranged on a mounting surface (82) and comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902);
a housing (7) arranged on the first metallic layer (902) of the integrated base plate (90);
a plurality of mounting elements (952); and
a plurality of screws (950), each of the plurality of screws (950) comprising a shaft and a head, wherein
the shaft of each of the plurality of screws (950) extends through a threaded hole in one of the plurality of mounting elements (952) and into a threaded hole in the mounting surface (82),
the head of each of the plurality of screws (950) exerts pressure on one of the plurality of mounting elements (952) in a vertical direction (y) towards the mounting surface (82),
each of the plurality of mounting elements (952) is attached to or monolithically formed with the housing (7), and
the plurality of mounting elements (952) are configured to transfer the pressure exerted on the mounting elements (952) by means of the screws (950) to the housing (7) such that the housing (7) is pressed on the first metallic layer (902).

2. The power semiconductor module arrangement of claim 1, wherein a contact surface between the housing (7) and the first metallic layer (902) is at least twice, at least 10 times, or at least 20 times the contact surface between each of the screw heads and the respective mounting element (952).

3. The power semiconductor module arrangement of claim 1 or 2, wherein the plurality of mounting elements (952) is arranged distant from the first metallic layer (902) in the vertical direction (y).

4. The power semiconductor module arrangement of any of claims 1 to 3, wherein the plurality of mounting elements (952) is formed by protrusions extending horizontally from the sidewalls of the housing (7).

5. The power semiconductor module arrangement of claim 4, wherein the sidewalls of the housing (7) comprise grooves and each of the plurality of mounting elements (952) engages with a respective one of the grooves.

6. The power semiconductor module arrangement of any of claims 1 to 5, further comprising a plurality of washers (956), wherein each of the plurality of washers (956) is arranged between a different one of the screw heads and the respective mounting element (952).

7. The power semiconductor module arrangement of any of the preceding claims, wherein the first metallic layer (902) and the second metallic layer (908) each comprise or consist of aluminum or an aluminum alloy.

8. The power semiconductor module arrangement of any of the preceding claims, wherein the reinforcing layer (904) and the ceramic substrate (906) each comprise one or more of AIN, Al₂O₃, SiC, BeO, BN, or Si₃N₄.

9. The power semiconductor module arrangement of any of the preceding claims, further comprising a coating layer (910) coating the second metallic layer (908).

10. The power semiconductor module arrangement of claim 9, wherein the coating layer (910) consists of or includes nickel, silver, gold, or palladium.

11. A method comprising
arranging an integrated base plate (90) on a mounting surface (82), the integrated base plate (90) comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902);
arranging a housing (7) on the first metallic layer (902) of the integrated base plate (90), wherein a plurality of mounting elements (952) is attached to or monolithically formed with the housing (7), and wherein each of the plurality of mounting elements (952) comprises at least one threaded hole;
inserting one of a plurality of screws (950) through each of the plurality of threaded holes in the mounting elements (952) such that a shaft of each of the plurality of screws extends through the respective through hole and into one of a plurality of threaded holes in the mounting surface (82); and
fastening the plurality of screws (950) such that the head of each of the plurality of screws (950) exerts pressure on the respective one of the plurality of mounting elements (952) in a vertical direction (y) towards the mounting surface (82), wherein the pressure exerted on the mounting elements (952) by means of the screws (950) is transferred to the housing (7) by means of the mounting elements (952) such that the housing (7) is pressed on the first metallic layer (902).

12. A power semiconductor module arrangement (300) comprising:
an integrated base plate (90) comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902); and
a housing (7), wherein
the first metallic layer (902) comprises a plurality of openings (930) extending from the first surface towards the reinforcing layer (904) such that defined portions of the reinforcing layer (904) are not covered by the first metallic layer (902),
the housing (7) is arranged on the first metallic layer (902) and comprises a plurality of protrusions (702), each of the plurality of protrusions (702) extending into a different one of the plurality of openings (930) and contacting the reinforcing layer (904).

13. The power semiconductor module arrangement (300) of claim 12, further comprising a mounting surface (82), wherein
the integrated base plate (90) is arranged on the mounting surface (82),
the housing (7) is attached to the mounting surface (82) by means of a plurality of screws (950), and
the housing is configured to press the integrated base plate (90) on the mounting surface (82) by means of the plurality of protrusions (702).

14. The power semiconductor module arrangement (300) of claim 13, wherein the mounting surface (82) is the surface of a heat sink.

## Amended claims

### Amended claims in accordance with Rule 137(2) EPC.

1. A power semiconductor module arrangement (200) comprising:
an integrated base plate (90) arranged on a mounting surface (82) and comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902);
a housing (7) arranged on the first metallic layer (902) of the integrated base plate (90);
a plurality of mounting elements (952); and
a plurality of screws (950), each of the plurality of screws (950) comprising a shaft and a head, wherein
the shaft of each of the plurality of screws (950) extends through a hole in one of the plurality of mounting elements (952) and into a threaded hole in the mounting surface (82),
the head of each of the plurality of screws (950) exerts pressure on one of the plurality of mounting elements (952) in a vertical direction (y) towards the mounting surface (82),
each of the plurality of mounting elements (952) is attached to or monolithically formed with the housing (7),
the plurality of mounting elements (952) are configured to transfer the pressure exerted on the mounting elements (952) by means of the screws (950) to the housing (7) such that the housing (7) is pressed on the first metallic layer (902),
the plurality of mounting elements (952) is formed by protrusions extending horizontally from the sidewalls of the housing (7), and
the sidewalls of the housing (7) comprise grooves and each of the plurality of mounting elements (952) engages with a respective one of the grooves.

2. The power semiconductor module arrangement of claim 1, wherein a contact surface between the housing (7) and the first metallic layer (902) is at least twice, at least 10 times, or at least 20 times the contact surface between each of the screw heads and the respective mounting element (952).

3. The power semiconductor module arrangement of claim 1 or 2, wherein the plurality of mounting elements (952) is arranged distant from the first metallic layer (902) in the vertical direction (y).

4. The power semiconductor module arrangement of any of claims 1 to 3, further comprising a plurality of washers (956), wherein each of the plurality of washers (956) is arranged between a different one of the screw heads and the respective mounting element (952).

5. The power semiconductor module arrangement of any of the preceding claims, wherein the first metallic layer (902) and the second metallic layer (908) each comprise or consist of aluminum or an aluminum alloy.

6. The power semiconductor module arrangement of any of the preceding claims, wherein the reinforcing layer (904) and the ceramic substrate (906) each comprise one or more of AlN, Al₂O₃, SiC, BeO, BN, or Si₃N₄.

7. The power semiconductor module arrangement of any of the preceding claims, further comprising a coating layer (910) coating the second metallic layer (908).

8. The power semiconductor module arrangement of claim 7, wherein the coating layer (910) consists of or includes nickel, silver, gold, or palladium.

9. A method comprising
arranging an integrated base plate (90) on a mounting surface (82), the integrated base plate (90) comprising a first metallic layer (902), a ceramic substrate (906) bonded directly to a first surface of the first metallic layer (902), a second metallic layer (908) bonded directly to the ceramic substrate (906) such that the ceramic substrate (906) is arranged between the first metallic layer (902) and the second metallic layer (908), and a reinforcing layer (904) embedded in the metallic layer (902) and having a greater strength than the first metallic layer (902);
arranging a housing (7) on the first metallic layer (902) of the integrated base plate (90), wherein a plurality of mounting elements (952) is attached to or monolithically formed with the housing (7), and wherein each of the plurality of mounting elements (952) comprises at least one hole;
inserting one of a plurality of screws (950) through each of the plurality of holes in the mounting elements (952) such that a shaft of each of the plurality of screws extends through the respective through hole and into one of a plurality of threaded holes in the mounting surface (82); and
fastening the plurality of screws (950) such that the head of each of the plurality of screws (950) exerts pressure on the respective one of the plurality of mounting elements (952) in a vertical direction (y) towards the mounting surface (82), wherein the pressure exerted on the mounting elements (952) by means of the screws (950) is transferred to the housing (7) by means of the mounting elements (952) such that the housing (7) is pressed on the first metallic layer (902), wherein the plurality of mounting elements (952) is formed by protrusions extending
horizontally from the sidewalls of the housing (7), and the sidewalls of the housing (7) comprise grooves and each of the plurality of mounting
elements (952) engages with a respective one of the grooves.
